Europäisches Patentamt

European Patent Office

Office européen des brevets

(11) Publication number: **0 441 374 A1**

# EUROPEAN PATENT APPLICATION

(21) Application number: 91101683.0

(51) Int. Cl.⁵: **H01L 29/92**, H01L 21/3205

(22) Date of filing: 07.02.91

(30) Priority: 07.02.90 JP 27795/90

(43) Date of publication of application:
14.08.91 Bulletin 91/33

(84) Designated Contracting States:
DE FR GB

(71) Applicant: KABUSHIKI KAISHA TOSHIBA
72, Horikawa-cho Saiwai-ku
Kawasaki-shi Kanagawa-ken 210(JP)

(72) Inventor: Mase, Yasukazu, c/o Intellectual

Property Div.
K. K. Toshiba, 1-1 Shibaura 1-chome
Minato-ku, Tokyo 105(JP)
Inventor: Abe, Masahiro, c/o Intellectual
Property Div.
K. K. Toshiba, 1-1 Shibaura 1-chome
Minato-ku, Tokyo 105(JP)

(74) Representative: Lehn, Werner, Dipl.-Ing. et al
Hoffmann, Eitle & Partner Patentanwälte
Arabellastrasse 4
W-8000 München 81(DE)

(54) Semiconductor device provided with capacitors.

(57) A semiconductor device provided with capacitors comprising a dielectric layer (22) arranged on a semiconductor substrate (30), a pair of upper and lower electrodes (21, 23) opposed to each other with the dielectric layer (22) interposed between them, and a pickup portion (24 or 25) extending continuous from each electrode (21 or 23), wherein the pattern edge of the upper electrode (23) from which its pickup portion (25) is excluded is positioned inside that of the lower electrode (21) from which its pickup portion (24) is excluded. The area of the upper electrode (23) pattern from which its pickup portion (25) is excluded is made smaller than that of the lower electrode (21) pattern from which its pickup portion (24) is excluded, so as to reduce the leak current of the capacitor.

F I G. 1A

F I G. 1B

EP 0 441 374 A1

## SEMICONDUCTOR DEVICE PROVIDED WITH CAPACITORS

The present invention relates to a semiconductor element provided with a multilayer wiring structure and, more particularly, it relates to a semiconductor device provided with capacitors which use wiring layers as electrodes.

Conventionally, the capacitor which is formed in a two-layer wiring structure, for example, is used as an element provided with multilayer wirings. A thermal oxide film of silicon dioxide, for example, is formed on a predetermined conductive semiconductor substrate and impurities are then introduced into a predetermined pattern area by the photolithographic technique to form circuit elements such as active and passive elements and resistors. Conductive metal layers are laminated on these circuit elements to electrically connect the elements. The so-called multilayer wiring structure is used to electrically connect the circuit elements which are formed in monolithic manner on the semiconductor substrate.

In order to form the wiring layers provided with the capacitor, a first wiring layer 12, 1.0 $\mu$m thick, made of A$\ell$ - Si is formed on a heat oxidizing film 11 on a semiconductor substrate (not shown) by the sputtering, photolithographic or reactive ion etching (or RIE) manner, as shown in Fig. 5A. A dielectric layer 13, about 1.0 $\mu$m thick, made of plasma (which will be hereinafter abridged as P) oxidizing silicon film is overlapped on a predetermined position of the first wiring layer 12 by the P - chemical vapor deposition (or CVD) method. A second wiring layer 14, 1.0 $\mu$m thick, made of A$\ell$ - Si, for example, is laminated on the dielectric layer 13 by the same manner as in the case of the first wiring layer 12. A capacitor is thus formed.

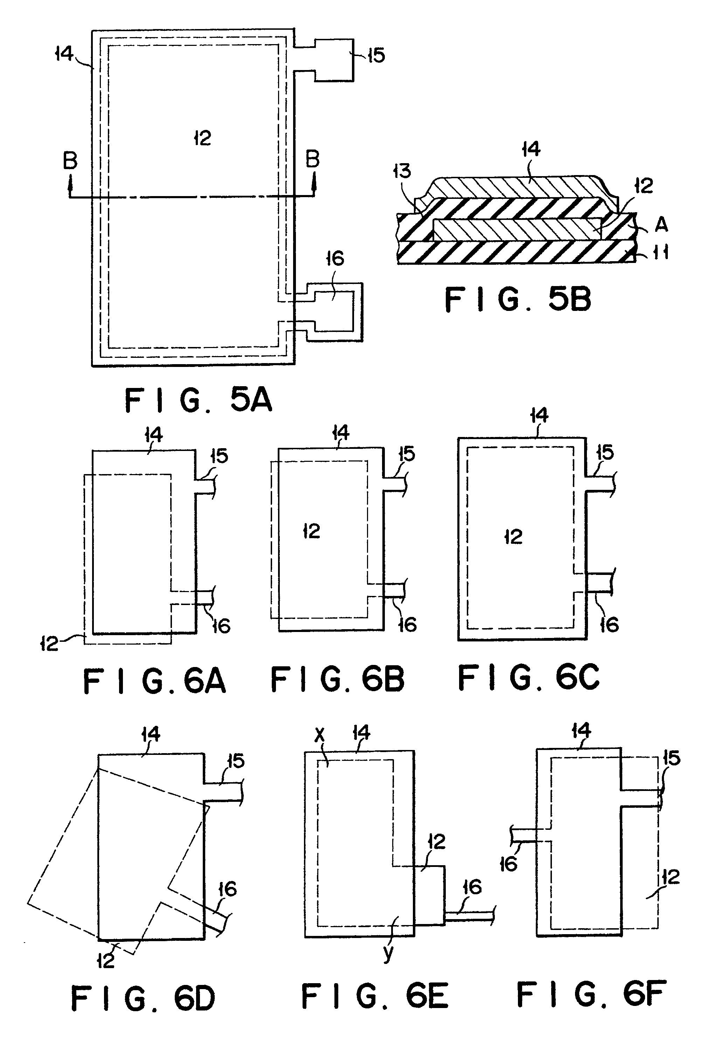

In the case of the capacitor formed as described above, the first wiring layer 12 serves as a lower electrode (which will be hereinafter referred to as the lower electrode 12) and the second wiring layer 14 serves as an upper electrode (which will be hereinafter referred to as the upper electrode 14). A pickup portion 15 extends from the upper electrode 14 and another pickup portion 16 extends from the lower electrode 12, as shown in Fig. 5A. The whole length of the pattern edge of the upper electrode 14 from which its pickup portion 15 is excluded is made longer by 2 $\mu$m, minimum, than that of the pattern edge of the lower electrode 12 from which its pickup portion 16 is excluded, usually considering pickups or leads of the wiring layers. Figs. 6A through 6F show both of the electrodes variously laminated one upon the other. The pattern edge of the upper electrode 14 whose area is larger than that of the lower electrode 12 is represented by a solid line and the pattern edge of the lower electrode 12 is denoted by a broken line. A part or whole of the pattern edge of the upper electrode 14 projected on the pattern edge of the lower electrode 12 is shifted from the pattern edge of the lower electrode 12 in any cases shown in Figs. 6A through 6F. Particularly Fig. 6D shows the lower electrode 12 extremely shifted from the upper electrode 14. In the case of the capacitor shown in Fig. 6E, the upper electrode 14 comprises a large area section x and a small area section y and the pickup portion 15 extends from the small area section y. The small area section y is sometimes projected outside from the pattern edge of the lower electrode 12 in this case. Further, Fig. 6F shows that the lower electrode 12 which is to be formed to have an area smaller than that of the upper electrode 14 becomes so large as to largely project outside from the pattern edge of the upper electrode 14.

In the case of the multilayer wiring structure which is used by the highly integrated semiconductor elements, the capacitor is recently formed as described above. The whole length of the pattern edge of the upper electrode is made longer than that of the pattern edge of the lower electrode, as described above. As shown in Fig. 5B, therefore, the dielectric matter A covering sides of the lower electrode 14 is used as a film for insulting the one layer from the other.

However, the dielectric matter A which is formed on the lower electrode 12 as the layers-insulating film is usually inferior in film quality at those portions thereof which cover the sides of the lower electrode 12. These portions of the matter A therefore serve as large leak paths. The leak value changes more greatly as the height of the side of the lower electrode 12 becomes larger. The amount of current leaked through a silicon dioxide layer itself formed by the P - CVD on a flat area is 2 - 3pA/mm$^2$ (when 0.5MV/cm is applied), but the amount of current leaked through a layer of P - silicon dioxide which covers the side, 1 $\mu$m high, of the electrode is 56 - 1000pA/mm$^2$ whose irregularity is quite large. The regularity of capacity value set is made low, having an error of + 42%, because of this capacitor leak, thereby preventing LSIs (or large scale integrated circuits) from being made high in accuracy and speed. In addition, the productivity of devices is made low because defective devices caused by the capacitor leak are kept high in number.

The object of the present invention is therefore to provide a semiconductor device provided with capacitors wherein a dielectric matter is formed not to include those layers-insulating layer portions which cover sides of an electrode and which causes current to be leaked therethrough so as to reduce the capacitor leak to a greater extent, make the irregularity of the capacity value lower, and enable the capacitor to be made with higher accuracy and productivity.

According to the present invention, there can be provided a semiconductor device provided with capacitors comprising a dielectric layer arranged on a semiconductor substrate. a pair of upper and lower electrodes opposed to each other with the dielectric layer interposed between them, and a pickup portion extending continuous from each electrode, wherein the pattern edge of the upper electrode from which its pickup portion is excluded is positioned inside that of the lower electrode from which its pickup portion is excluded.

It is preferable in this case that the pattern edge of the upper electrode is separated inward from that of the lower electrode by about 1.0 $\mu$m or more.

This invention can be more fully understood from the following detailed description when taken in conjunction with the accompanying drawings, in which:

Fig. 1A is a plan showing the main portion of an example of the semiconductor device provided with an capacitor according to the present invention;

Fig. 1B is a sectional view taken along a line B - B in Fig. 1A;

Figs. 2A through 2C are intended to explain the positional state of electrodes in the case of the semiconductor device provided with the capacitor according to the present invention;

Figs. 3 and 4 are graphs showing current characteristics of capacitor leak;

Fig. 5A is a plan showing the main portion of the semiconductor device provided with the conventional capacitor which uses wiring layers;

Fig. 5B is a sectional view taken along a line B - B in Fig. 5A; and

Figs. 6A through 6F are intended to explain the positional state of electrodes in the case of the semiconductor device provided with the conventional capacitor.

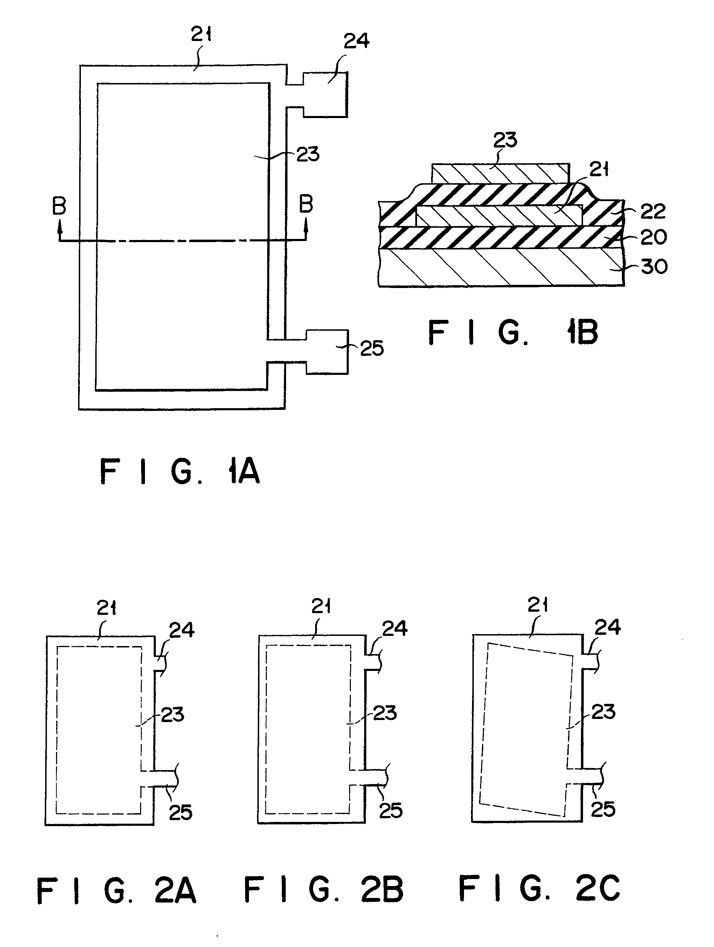

An embodiment of the present invention will be described with reference to Figs. 1A through 4. Reference numeral 30 in Fig. 1B represents a semiconductor substrate made of silicon, for example. The semiconductor substrate 30 includes predetermined elements selected from a group of circuit elements such as active and passive elements and resistors. A thermal silicon oxide film 20 is formed on the semiconductor 30. A layer of A$\ell$ - Si formed about 1.0 $\mu$m thick by the sputtering manner, for example, is shaped to a predetermined pattern by the lithography and reactive ion etching techniques to form a lower electrode 21 on the thermal silicon oxide film 20. A layers-insulating layer (or dielectric layer) 22 made of P - silicon oxide and formed about 1.0 $\mu$m thick by the P - CVD (chemical vapor deposition) and resist etchback manners is coated on a first wiring layer which includes the lower electrode 21. The layers-insulating layer 22 is provided with a through-hole which has a predetermined size. A second wiring layer which includes a predeterminedly-pattterned upper electrode 23 is formed on the layers-insulating layer 22. A capacitor is formed by these two wiring layers.

Fig. 1A is a plan showing the electrodes portion of the capacitor thus arranged. As apparent from Fig. 1A, both of the electrodes 21 and 23 are provided with pickup portions 24 and 25 which serve as current or voltage applying paths.

In the case of this example, the pattern edge of the upper electrode 23 in which the pickup portion 25 is not included is arranged inside the pattern edge of the lower electrode 21 in which the pickup portion 24 is not included. When a mask is to be designed, therefore, the pattern edge of the upper electrode 23 from which the pickup portion 25 is excluded is made smaller than that of the lower electrode 21 from which the pickup portion 24 is excluded to form such a capacitor structure as has no side which is inferior in film quality. More specifically, the pattern edge of the upper electrode 23 is separated inward from that of the lower electrode 21 by 1.2 $\mu$m. Practically, the pattern edge of the upper electrode 23 may be separated from that of the lower electrode 21 by substantially more than 1.0 $\mu$m.

Although the P - silicon oxide has been used as the layers - insulating or dielectric layer for the capacitor in this example, other dielectric matters may be used as a single or plural components and the thickness of its or their layer may be changed.

Figs. 2A through 2C are plans showing the positional relation between the lower 21 and the upper electrode 23 which form the capacitor, and the upper electrode 23 is denoted by a broken line and the lower electrode 21 by a solid line in Figs. 2A through 2C.

As apparent from Figs. 2B and 2C, it may be arranged that the positional relation of the both electrodes is not distinctly similar to each other and that the pattern edge of the upper electrode 23 from which the pickup portion 25 is excluded is positioned inside that of the lower electrode 21 from which the pickup portion 24 is excluded. Polycrystal silicon and tungsten can be used as the material of which the upper and lower electrodes 21 and 23 or the wiring layers are made. Instead of P - silicon oxide, other insulating materials can be used as the dielectric matter. The capacitor thus formed can be applied to various kinds of devices in addition to bipolar elements. The passivation layer and others are laminated on the upper electrode 23 in some of these cases.

According to the semiconductor device in which the capacitor is arranged in the multilayer wiring as seen in this example, the area of the upper electrode for the capacitor is made smaller than that of the lower electrode and the pattern edge of the upper electrode from which the pickup portion is excluded is formed to position inside that of the lower electrode. The capacitor can be thus realized not to use the insulating layer which is formed on the sides of the lower electrode and whose film quality is inferior to cause current leak, thereby enabling the semiconductor device to have extremely enhanced accuracy and homogeneity.

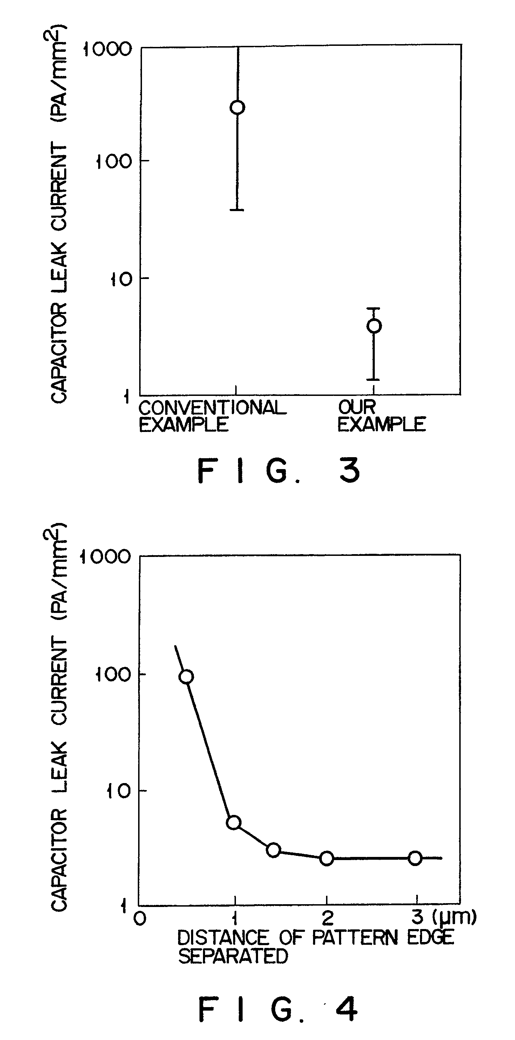

Therefore, merits as seen in Figs. 3 and 4 can be attained.

a) The leak current of the capacitor can be reduced to a greater extent. This enables the capacity of the capacitor to be made higher in accuracy and regularity. Namely, a variation in the capacitor capacity caused by the lead current was conventionally + 42%, but it can be made lower than + 5% in the case of this example. This enables LSIs to be made higher in speed.

b) The number of devices which are made defective because of the leak current of the capacitor can be reduced to a greater extent and the productivity of devices can be thus made higher by 6% - 15%, as compared with the conventional cases.

c) To realize the present invention, it is quite enough only to design the patterns of the upper and lower electrodes, while using the conventional process as it is. The cost of a device can be thus made unchanged but reduced corresponding to the enhanced productivity.

d) The dielectric breakdown voltage of the capacitor was 425V average in the conventional cases but it can be extremely enhanced to 637V average in the case of this example.

Fig. 3 is intended to show the volume of the leak current in the case of this example compared with that in the case of the conventional one, and Fig. 4 is a graph showing how the leak current volume of the capacitor changes depending upon the distance by which the pattern edge of the upper electrode is separated inward from that of the lower electrode.

Reference signs in the claims are intended for better understanding and shall not limit the scope.

## Claims

1. A semiconductor device provided with capacitors characterized by comprising:

a dielectric layer (22) arranged on a semiconductor substrate (30);

a pair of upper and lower electrodes (21, 23) opposed to each other with the dielectric layer (22) interposed between them; and

a pickup portion (24 or 25) extending continuous from each electrode (21 or 23);

wherein the pattern edge of the upper electrode (23) from which its pickup portion (25) is excluded is positioned inside that of the lower electrode (21) from which its pickup portion (24) is excluded.

2. The semiconductor device provided with capacitors according to claim 1, characterized in that the interval by which the pattern edge of the upper electrode (23) is separated inward from that of the lower electrode (21) is longer than 1.0 $\mu$m.

3. The semiconductor device provided with capacitors according to claim 1, characterized in that the dielectric layer (22) is a layers-insulating one interposed between a first and a second wiring layer laminated on the semiconductor substrate.

4. The semiconductor device provided with capacitors according to claim 3, characterized in that the lower electrode (21) is included in the first wiring layer and the upper electrode (23) is included in the second wiring layer.

5. The semiconductor device provided with capacitors according to claim 3, characterized in that the dielectric layer (22) is a pile of silicon oxide or silicon nitride formed by the plasma chemical vapor deposition manner.

6. The semiconductor device provided with capacitors according to claim 4, characterized in that the upper and lower electrodes (21, 23) are made of polycrystal silicon or tungsten.

F I G. 1A

F I G. 1B

F I G. 2A   F I G. 2B   F I G. 2C

F I G. 3

F I G. 4

F I G. 5A

F I G. 5B

F I G. 6A

F I G. 6B

F I G. 6C

F I G. 6D

F I G. 6E

F I G. 6F

European
Patent Office

**EUROPEAN SEARCH
REPORT**

Application Number

**EP 91 10 1683**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | EP-A-0 192 989 (NEC CORP.)<br>* pages 1 - 2; figures 1, 2 * * pages 7 - 8; figures 3, 4 *<br>— — — | 1,3,4,6,2,5 | H 01 L 29/92<br>H 01 L 21/3205 |
| Y,A | IEEE TRANSACTIONS ON CIRCUITS AND SYSTEMS. vol. 36, no. 6, June 1989, NEW YORK US pages 912 - 916; Rajinder SINGH et al.: "A fast and area-efficiency BWC array D/A and A/D conversion scheme"<br>* figures 3a, 3c *<br>— — — | 2,1,3-6 | |
| Y,A | US-A-4 599 678 (MICHAEL R. WERTHEIMER ET AL.)<br>* column 2, line 67 - column 3, line 11; figure 1 * * column 4, lines 13 - 31 *<br>— — — | 5,1,3,4 | |
| X,A | PATENT ABSTRACTS OF JAPAN vol. 5, no. 186 (E-84)(858) 25 November 1981,<br>& JP-A-56 112750 (NIPPON DENKI K.K.) 05 September 1981,<br>* the whole document *<br>— — — | 1,3,4,2,5,6 | |
| X,A | PATENT ABSTRACTS OF JAPAN vol. 9, no. 310 (E-364)(2033) 06 December 1985,<br>& JP-A-60 144960 (NIPPON DENKI K.K.) 31 July 1985,<br>* the whole document *<br>— — — | 1,3,4,2,5,6 | TECHNICAL FIELDS SEARCHED (Int. Cl.5)<br><br>H 01 L<br>H 01 G |
| X,A | US-A-4 654 690 (KEISUKE OKADA ET AL.)<br>* column 1, lines 12 - 23; figures 1, 2 * * column 2, line 33 - column 3, line 8; figures 3-5 *<br>— — — | 1,3,4,2,5,6 | |
| A | US-A-4 638 400 (DALE M. BROWN ET AL.)<br>* column 4, line 49 - column 5, line 33; claims 1, 4, 11; figures 2A-2D *<br>— — — — — | 1-6 | |

The present search report has been drawn up for all claims

| Place of search | Date of completion of search | Examiner |
|---|---|---|
| Berlin | 25 March 91 | KLOPFENSTEIN P R |